# FASCICULE DE BREVET EUROPEEN

(11) **EP 3 405 968 B1**
(45) Date de publication et mention de la délivrance du brevet: **24.06.2026**
(21) Numéro de dépôt: 17706270.0
(22) Date de dépôt: 13.01.2017
(51) Int. Cl.: H01H 85/30, H01H 85/46, H02H 3/04, H01M 10/48

(54) **PROCÉDÉ ET DISPOSITIF DE PROTECTION D'UNE ARCHITECTURE ÉLECTRIQUE**
VERFAHREN UND VORRICHTUNG ZUM SCHUTZ EINER ELEKTRISCHEN ARCHITEKTUR
METHOD AND DEVICE FOR PROTECTING AN ELECTRICAL ARCHITECTURE

(30) Priorité: 19.01.2016 FR 1650416
(43) Date de publication de la demande: 28.11.2018
(73) Titulaire: Ampere SAS, 92100 Boulogne-Billancourt (FR)
(72) Inventeur: MARCHAL, Caroline, 75015 Paris (FR); RECOUVREUR, Philippe, 92120 Montrouge (FR)
(74) Mandataire: Renault Group
(86) Numéro de dépôt international: PCT/FR2017/050086
(87) Numéro de publication internationale: WO 2017/125668

(56) Documents cités:
- EP-A2- 2 393 102
- WO-A1-2008/098532
- DE-U1- 20 214 002
- US-A1- 2004 036 480

## Description

La présente invention concerne un procédé de protection d'une architecture électrique comprise notamment dans un véhicule et comprenant un fusible de protection ainsi qu'un dispositif de protection pour la mise en œuvre de ce procédé.

L'invention concerne également un programme d'ordinateur ainsi qu'un véhicule notamment un véhicule automobile comportant un tel dispositif de protection.

Dans l'état de la technique on connaît une architecture électrique de véhicule telle que celle qui est décrite dans un document FR2967823, comprenant un dispositif de protection et une batterie pourvue de modules reliés électriquement entre eux par des barres de jonction. Ce dispositif de protection est défini pour détecter un échauffement au niveau des barres de jonction avant qu'il ne soit transmis aux modules de la batterie et éviter ainsi tout endommagement de cette dernière. Pour ce faire, ce dispositif de protection comprend une unité de traitement reliée à des fusibles thermiques qui sont agencés au niveau de différentes zones définies sur ces barres de jonction. Ainsi, dès lors qu'une de ces zones connaît une élévation de température allant au-delà d'un seuil prédéfini, le fusible correspondant fond et le calculateur active un mode d'utilisation dégradé de la batterie correspondant à une limitation d'un courant de charge ou de décharge de cette dernière en dessous d'un certain seuil.

Cependant un des inconvénients majeur d'un tel dispositif de protection est lié au fait qu'il est nécessaire de remplacer systématiquement le fusible thermique défectueux qui a fondu pour que ce dispositif de protection soit de nouveau opérationnel et que le fonctionnement de la batterie ne s'en trouve pas altéré et par extension celui du véhicule dans lequel elle est agencée.

En outre un tel dispositif de protection présente également un coût de mise en œuvre et de fonctionnement élevé lié par exemple au remplacement des fusibles défectueux.

Le document EP2393102A2 ou le document WO2008/098532 divulgue un procédé ne surmontant pas tous ces inconvénients, ou de façon non optimale.

La présente invention vise à pallier ces inconvénients liés aux dispositifs et procédés de protection de l'état de la technique.

Dans ce dessein, l'invention concerne un procédé de protection d'une architecture électrique comprenant un dispositif de protection pourvu d'un fusible de protection apte à fondre dans un mode de fonctionnement dégradé durant lequel un courant de rupture d'une intensité supérieure à un seuil circule dans l'architecture, le procédé comportant en outre, dans un mode de fonctionnement nominal les étapes suivantes :
- estimation périodique d'une température dudit fusible, et
- pilotage d'une intensité d'un courant utile circulant dans ledit fusible de sorte que la température estimée reste inférieure à une température de fusion dudit fusible.

L'invention concerne encore les étapes suivantes:
- le procédé comprend une étape de définition d'une première consigne de limitation de l'intensité du courant à une première intensité maximale circulant dans ledit fusible ;
- l'étape de pilotage comprend une étape de définition d'une deuxième consigne de limitation de l'intensité de courant utile à une deuxième intensité maximale du courant si la température estimée est supérieure à une température seuil ;

Dans d'autres modes de réalisation:
- l'étape d'estimation périodique de la température du fusible comprend :
   - une étape de mesure de la température du fusible, notamment d'une lamelle du fusible, ou
   - une étape de mesure de l'intensité du courant circulant dans ledit fusible, notamment d'une lamelle du fusible, et
   - une étape de calcul de la température à partir de l'intensité mesurée et d'un modèle de données mettant en relation des températures avec des intensités relatives audit fusible ;
- le procédé comprend une étape de détermination d'une température seuil à partir d'une différence entre la température de fusion du fusible et une variation de températures relative à une énergie que le fusible est susceptible de dissiper, laquelle énergie étant inférieure à une énergie de fusion de ce fusible ;
- l'étape d'estimation comprend une étape d'ajustement d'une température mesurée ou calculée du fusible à partir d'une température ambiante déterminée dudit fusible, et/ou
- les étapes d'estimation et de pilotage sont mises en œuvre par un algorithme du type régulateur PID ou analogue.

L'invention concerne également un dispositif de protection d'une architecture électrique mettant en œuvre un tel procédé de protection, le dispositif comportant un fusible de protection apte à fondre dans un mode de fonctionnement dégradé durant lequel un courant de rupture d'une intensité supérieure à un seuil circule dans l'architecture, le dispositif comportant en outre, dans un mode de fonctionnement nominal :
- un élément d'estimation périodique d'une température dudit fusible, et
- un élément de pilotage d'une intensité d'un courant utile circulant dans ledit fusible de sorte que la température estimée reste inférieure à une température de fusion dudit fusible.

Et encore:
- l'élément d'estimation comprend une unité de traitement, au moins un capteur de température du fusible, un dispositif de détermination d'une température ambiante du fusible et/ou au moins un dispositif de mesure de l'intensité du courant circulant dans ledit fusible ;
- l'élément de pilotage comprend l'unité de traitement et un dispositif de régulation de l'intensité du courant circulant dans le fusible, et/ou
- l'unité de traitement est connectée audit au moins un capteur de température, aux dispositifs de mesure et de régulation de l'intensité du courant circulant dans le fusible ainsi qu'au dispositif de détermination d'une température ambiante du fusible.

L'invention concerne en outre un véhicule notamment électrique ou hybride, comprenant une architecture électrique pourvue d'un tel dispositif de protection.

D'autres avantages et caractéristiques de l'invention apparaîtront mieux à la lecture de la description d'un mode de réalisation préféré qui va suivre, en référence aux figures, réalisé à titre d'exemple indicatif et non limitatif :
- la figure 1 représente une vue schématique d'un dispositif de protection compris dans une architecture électrique selon le mode de réalisation de l'invention ;
- la figure 2 représente une vue schématique d'un fusible de protection selon le mode de réalisation de l'invention ;
- la figure 3 est un logigramme relatif à un procédé de protection d'une architecture électrique selon le mode de réalisation de l'invention ;
- la figure 4A est une représentation graphique d'une intensité d'un courant circulant dans le fusible en fonction du temps relative à une deuxième variante d'une étape de pilotage de cette intensité du procédé de protection selon le mode de réalisation de l'invention ;
- la figure 4B est une représentation graphique d'une température du fusible en fonction du temps relative à la deuxième variante de l'étape de pilotage selon le mode de réalisation de l'invention ;
- la figure 4C est une représentation graphique de l'intensité circulant dans le fusible en fonction de la température du fusible relative à la deuxième variante de l'étape de pilotage selon le mode de réalisation de l'invention ;
- la figure 5A est une représentation graphique de l'intensité du courant circulant dans le fusible en fonction du temps relative à une troisième variante de l'étape de pilotage de cette intensité du procédé de protection selon le mode de réalisation de l'invention, et
- la figure 5B est une représentation graphique de la température du fusible en fonction du temps relative à la troisième variante de l'étape de pilotage selon le mode de réalisation de l'invention.

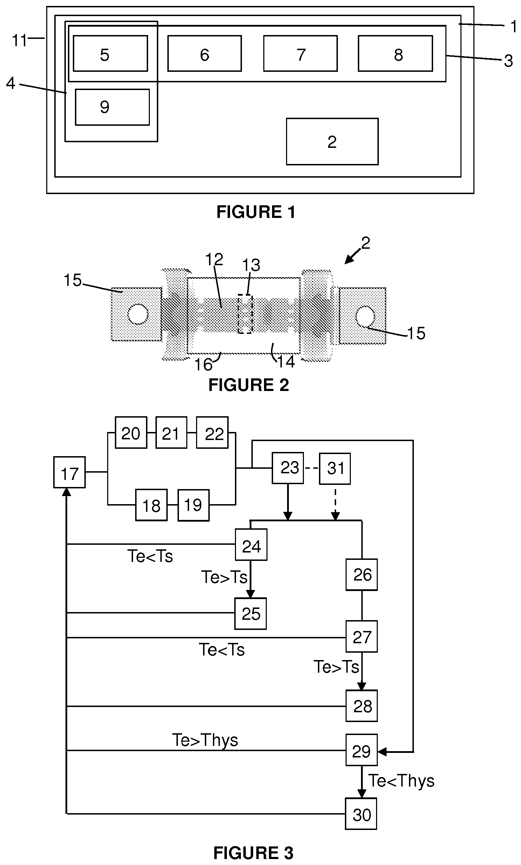

Dans un mode de réalisation représenté sur la figure 1, le dispositif de protection 1 d'une architecture électrique 11 comprend un fusible 2 de protection, un élément d'estimation 3 d'une température Te du fusible 2 et un élément de pilotage 4 d'une intensité I d'un courant utile circulant dans ledit fusible 2. Un tel dispositif de protection 1 est mis en en œuvre de préférence au sein d'une architecture électrique 11 d'un véhicule automobile, notamment d'un véhicule électrique ou encore hybride.

Le fusible 2 illustré sur les figures 1 et 2, est apte à fondre dans un mode de fonctionnement dégradé durant lequel un courant de rupture/surcharge d'une intensité supérieure à un seuil circule dans l'architecture 11. Ce mode de fonctionnement dégradé peut être défini comme étant une situation de panne immobilisante.

Ce fusible 2 comprend une lamelle 12 métallique encore appelée lame fusible 2, par exemple en cuivre, comportant une zone sensible 13 de fusion configurée pour fondre lorsque l'intensité supérieure du courant de rupture est supérieure à un seuil. La lamelle 12 comprend deux extrémités qui sont pourvues chacune d'une languette de connexion 15. De telles languettes de connexion 15 sont définies pour être connectées à un circuit électrique de l'architecture électrique 11. Dans ce fusible 2, cette languette 12 est comprise dans un carter 16 formant une enveloppe fermée contenant du sable 14 permettant une coupure franche de la zone sensible 13 lorsqu'elle a fondue en évitant le maintien d'un passage de courant à travers un arc électrique.

Ainsi que nous l'avons vu, ce dispositif 1 comprend dans un mode de fonctionnement nominal un élément d'estimation 3 périodique d'une température Te dudit fusible 2 ainsi qu'un élément de pilotage 4 du courant d'intensité I qui circule dans le fusible 2 et donc dans la lamelle 12 de ce dernier.

L'élément d'estimation 3 périodique comprend une unité de traitement 5, un dispositif de mesure 6 de l'intensité I du courant circulant dans ledit fusible 2 et au moins un capteur de température 7 du fusible 2 qui peut être agencé sur la languette de connexion du fusible 2. Cet élément d'estimation 3 comprend également un dispositif de détermination 8 de la température ambiante du fusible 2 qui est par exemple un capteur de température ambiante agencé dans un environnement immédiat du fusible 2. L'unité de traitement 5 peut être un ordinateur de bord du véhicule comprenant au moins une unité de calcul pourvue de ressources matérielles et logicielles, plus précisément d'au moins un processeur coopérant avec des éléments de mémoire. Cette unité de traitement 5 est apte à exécuter des instructions pour la mise en œuvre d'un programme d'ordinateur.

L'élément de pilotage 4 comprend l'unité de traitement 5 et un dispositif de régulation 9 de l'intensité I du courant circulant dans le fusible 2.

Dans ces conditions, l'unité de traitement 5 est connectée au capteur de température 7 ainsi qu'aux dispositifs de mesure et de régulation 6, 9 de l'intensité I du courant circulant dans fusible 2 ainsi qu'au dispositif de détermination 8 de la température ambiante du fusible 2.

Dans ce dispositif de protection 1, les éléments de mémoire de l'unité de traitement 5 comprennent, un modèle de données relatif audit fusible 2 mettant en relation des températures de lamelle 12 du fusible 2 et des intensités susceptibles de la traverser. Ce modèle de données est défini en fonction des caractéristiques du fusible 2 de ce dispositif de protection 1. Ce modèle de données peut être obtenu, soit après des mesures expérimentales de température et d'intensité de courant circulant dans le fusible 2 en faisant par exemple varier cette intensité, soit après un calcul prenant en compte les caractéristiques techniques du fusible 2. Dans ce modèle de données, les températures et intensités peuvent tenir compte de températures ambiantes du fusible 2. Un tel modèle de données est préalablement déterminé et archivé dans les éléments de mémoire de l'unité de traitement 5.

Les éléments de mémoire de l'unité de traitement 5 comprennent également un algorithme de calcul de type régulateur PID (acronyme de « Proportionnelle Intégrale et Dérivée ») ou analogue pour la mise en œuvre notamment d'une étape de pilotage du procédé décrite par la suite.

En référence à la figure 3, le dispositif 1 est apte à mettre en œuvre un procédé de protection de cette architecture électrique 11 comprenant un tel dispositif 1 pourvu de ce fusible 2 de protection.

Dans un mode de fonctionnement nominal, ce procédé comprend une étape d'estimation 17 périodique de la température Te du fusible 2. Lors de cette étape 17, l'évaluation de la température Te peut être réalisée selon deux alternatives. En effet, dans la première alternative, l'étape d'estimation 17 comprend une étape de mesure 18 de cette température Te du fusible 2, notamment de la lamelle 12 du fusible 2, à partir de l'unité de traitement 5 qui est reliée au capteur de température 7 agencé au niveau d'une des languettes 15 de connexion du fusible 2. Lors de cette première alternative, l'étape d'estimation 17 peut comprendre une étape d'ajustement 19 de cette température mesurée à partir d'une température ambiante Ta déterminée dudit fusible 2. Plus précisément lors de cette étape d'ajustement 19, la température ambiante Ta présente dans l'environnement immédiat du fusible 2 est mesurée à partir de l'unité de traitement 5 qui est connectée au dispositif de détermination 8 de cette température ambiante du fusible 2. Cette température ambiante Ta est alors prise en compte par l'unité de traitement 5 afin de réaliser une estimation de la température Te du fusible 2.

Dans la deuxième alternative, l'étape d'estimation 17 comprend une étape de mesure 20 de l'intensité I du courant circulant dans le fusible 2 à partir de l'unité de traitement 5 qui est reliée au dispositif de mesure 6 de l'intensité I du courant circulant dans le fusible 2. Cette étape de mesure 20 comprend une étape de calcul 21 de la température Te à partir de l'intensité I mesurée et du modèle de données relatif audit fusible 2 mettant en relation des températures de lamelle 12 du fusible 2 avec des intensités susceptibles de la traverser. Dans cette deuxième alternative, l'étape d'estimation 17 peut comprendre une étape d'ajustement 22 de cette température à partir d'une température ambiante Ta déterminée dudit fusible 2. Plus précisément, dans le modèle de données, la température déterminée du fusible 2 pour une intensité donnée peut être ajustée en fonction de la température ambiante Ta présente dans l'environnement immédiat du fusible 2, laquelle température ambiante Ta est mesurée à partir de l'unité de traitement 5 qui est connectée au dispositif de détermination 8 de la température ambiante du fusible 2.

Le procédé comprend ensuite une étape de pilotage 23 de l'intensité I du courant utile circulant dans le fusible 2 de sorte que la température Te estimée de ce dernier reste inférieure à une température de fusion Tf du fusible 2. Cette température de fusion Tf correspond à la température à laquelle la lamelle 12 du fusible 2 est susceptible de fondre lorsqu'un courant de rupture/surcharge circule dans le fusible 2 engendrant la fusion de ce dernier sous l'effet d'une énergie de fusion Ef qui fait fondre la lamelle 12 de ce fusible 2. Cette étape de pilotage 23 de l'intensité I peut être mise en œuvre selon trois variantes. Dans le cadre de la réalisation de cette étape de pilotage 23, l'unité de traitement 5 met en œuvre un mécanisme de régulation de l'intensité I circulant dans le fusible 2 à partir de l'algorithme de calcul de type régulateur PID (acronyme de « Proportionnelle Intégrale et Dérivée ») ou analogue comprenant de préférence une composante proportionnelle et/ou une composante intégrale. Plus précisément, l'unité de traitement 5 en exécutant cet algorithme est apte à réaliser les différentes variantes de cette étape de pilotage 23.

Dans, la première variante, cette étape de pilotage 23 comprend une étape de comparaison 24 de la température Te avec une température seuil Ts. Cette température seuil Ts qui est inférieure à la température de fusion Tf, correspond à une température pour laquelle les caractéristiques du fusible 2 et donc de la lamelle 12 ont été définies pour un fonctionnement optimal de ce dernier.

Dans ces conditions, si la température estimée Te est inférieure à la température seuil Ts, soit Te < Ts, alors l'intensité I du courant circulant dans le fusible 2 n'est pas modifiée. Dès lors, le procédé prévoit alors de nouveau la réalisation de l'étape d'estimation 17 périodique de la température Te.

A l'inverse, si la température estimée Te est supérieure à la température seuil Ts, soit Te > Ts, alors l'étape de pilotage 23 comprend une étape de définition 25 d'une deuxième consigne de limitation de l'intensité I du courant à une deuxième intensité maximale Im2. Cette intensité maximale Im2 du courant correspond à une intensité adaptée aux caractéristiques techniques du fusible 2 et donc de la lamelle afin d'assurer un fonctionnement optimal de ce fusible 2. Par la suite, le procédé prévoit de nouveau la réalisation de l'étape d'estimation 17 périodique de la température Te. Dans cette configuration, l'intensité I du courant circulant dans le fusible 2 est alors maintenue à une valeur inférieure ou égale à celle de la deuxième intensité maximale Im2 ce qui permet d'éviter que la température Te du fusible qui est mesurée périodiquement n'atteigne la température de fusion Tf.

Dans la deuxième variante, l'étape de pilotage comprend une étape de définition 26 d'une première intensité maximale Im1 de l'intensité I du courant utile circulant dans ledit fusible 2. Plus précisément, lors de cette étape 26, l'intensité I du courant circulant dans le fusible 2 ne peut excéder cette première intensité maximale Im1 c'est-à-dire que l'intensité I traversant la lamelle 12 de ce fusible 2 est inférieure ou égale à cette première intensité maximale Im1, soit I ≤ Im1. Dans cette variante, l'étape de pilotage 23 comprend également une étape de comparaison 27 de la température Te estimée à la température seuil Ts. Dans ces conditions, si la température estimée Te est inférieure à la température seuil Ts, soit Te < Ts, alors l'intensité I du courant circulant dans le fusible 2 n'est pas modifiée. Dès lors, le procédé prévoit alors de nouveau la réalisation de l'étape d'estimation 17 périodique de la température Te.

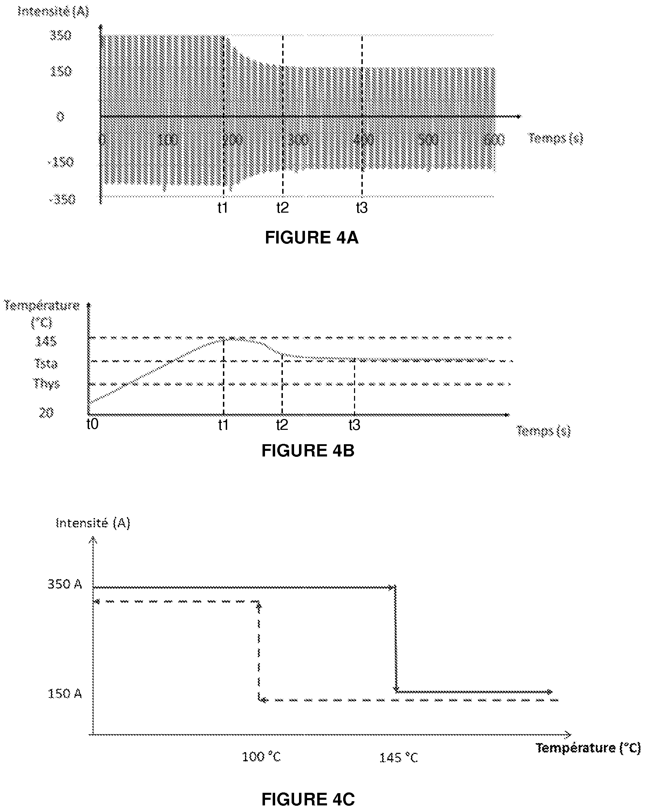

A l'inverse, si la température estimée Te est supérieure à la température seuil Ts, soit Te > Ts, alors l'étape de pilotage 23 comprend une étape de définition 28 de la deuxième consigne de limitation de l'intensité I du courant à la deuxième intensité maximale Im2. Cette deuxième intensité maximale Im2 est inférieure à la première intensité maximale Im1. L'étape de pilotage 23 prévoit ensuite la réalisation de l'étape d'estimation 17 périodique de la température Te du fusible 2 et comprend ensuite une nouvelle étape de comparaison 29 de la température Te estimée avec une température d'hystérésis Thys. Dans ces conditions, si la température estimée Te est inférieure à la température d'hystérésis Thys, soit Te < Thys, alors l'étape de pilotage 23 prévoit une étape d'annulation 30 de la deuxième consigne de limitation. Par la suite, les étapes d'estimation 17 et de pilotage 23 sont de nouveaux réalisées. On notera à l'inverse que si la température estimée Te est supérieure à la température d'hystérésis Thys, soit Te > Thys, alors les étapes d'estimation 17 et de comparaison 29 sont de nouveaux réalisées. On notera à titre d'exemple sur la figure 4C, la température seuil est de 145°C et la température d'hysteresis Thys est de 100°C.

En référence aux figures 4A à 4C, dans un exemple illustrant cette variante du procédé de l'étape de pilotage 23, entre des instants t0 et t1, l'intensité I du courant circulant dans ce fusible 2 est limitée à la première intensité maximale Im1 qui est ici de 350A suite à la réalisation de l'étape de définition 26 de la première consigne. Entre ces instants t0 et t1, la température Te estimée périodiquement augmente progressivement jusqu'à ce que cette température Te dépasse la température seuil Ts qui est ici de 145°C. Dès lors dans ces conditions, la température Te estimée à l'instant t1 étant supérieure à la température seuil Ts, soit Te > Ts, l'intensité I du courant circulant dans le fusible 2 est alors limitée à la deuxième intensité maximale Im2 qui est ici de 150A, suite à la mise en œuvre de l'étape de définition 28 de la deuxième consigne. Ainsi, entre des instants t1 et t2, l'intensité I décroît jusqu'à atteindre la deuxième intensité maximale Im2. Une telle diminution de l'intensité I engendre également une baisse de la température Te. En particulier, cette température Te continue de baisser jusqu'à un instant t3 où elle converge vers une température stabilisée Tsta, ici de 120°C. Ensuite dans la mesure où la température Te estimée est inférieure à la température d'hystérésis qui est ici de 100°C, l'étape de pilotage 23 prévoit alors l'étape d'annulation 30 de la deuxième consigne de limitation.

On notera dans ces première et deuxième variantes, que le régulateur PID comprend de préférence uniquement la composante proportionnelle et peut ainsi être défini pas l'équation suivante :
Im2 = Kp x (Te - Ts), avec Kp correspondant au gain proportionnel.

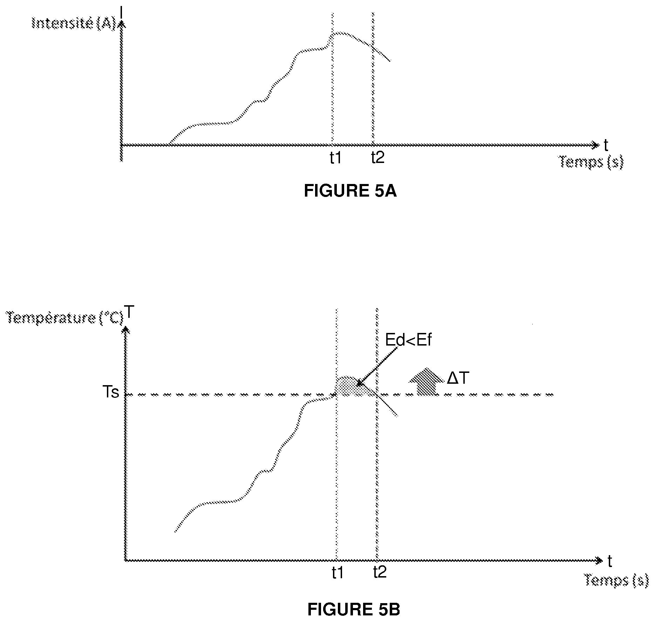

Dans la troisième variante, ce procédé comprend une étape de pilotage 23 similaire à celle décrite dans le cadre de la première ou la deuxième variante. A la différence de ces deux variantes, dans cette troisième variante, le procédé comprend une étape de détermination 31 d'une température seuil Ts à partir de la différence entre la température de fusion Tf du fusible 2 et d'une variation de températures ΔT relative à une énergie Ed que le fusible 2 est susceptible de dissiper et qui est inférieure à l'énergie de fusion Ef de ce fusible 2 soit Ed < Ef, visible sur la figure 5. Plus précisément cette énergie Ed est définie par l'équation suivante :
Ed= m Cp ∫ΔT dt, avec m la masse de la lamelle 12 du fusible 2 et Cp sa capacité calorifique.

En référence à la figure 5A et 5B, dans cette troisième variante, lorsque la température estimée Te est supérieure à cette température seuil Ts ainsi déterminée, soit Te > Ts, alors à un instant t1, l'étape de pilotage 23 met en œuvre l'étape de définition 24, 27 de la deuxième consigne de limitation de l'intensité de courant I à la deuxième intensité maximale Im2 du courant et ce, jusqu'à un instant t2 où la température estimée Te est inférieure à la température seuil Ts. Ainsi entre les instants t1 et t2, cette intensité I est réduite progressivement de manière continue dès que la température Te est supérieure à la température seuil Ts sans atteindre la température de fusion Tf du fusible 2. Autrement dit, la température de seuil Ts ainsi déterminée est donc très proche de la température de fusion Tf. Dans cette troisième variante, l'étape de pilotage 23 permet de réguler au plus juste l'intensité I du courant et donc la température Te du fusible 2. On notera que la température seuil Ts ainsi déterminée est supérieure à la température seuil expérimentale/théorique du fusible 2 notamment utilisé dans le cadre des première et deuxième variantes, mais inférieure à la température de fusion Tf du fusible 2.

Dans cette troisième variante le régulateur PID peut comprendre les composantes proportionnelle et intégrale, et correspondre à l'équation suivante : Im2 = Kp x (Te - Ts) + KI x ∫ ΔTdt, avec Kp qui est le gain proportionnel et KI le gain intégral.

En outre ce procédé peut comprendre une étape d'alerte d'un utilisateur du véhicule comprenant une telle architecture électrique 11, lorsque dans les variantes de l'étape de pilotage 23, l'étape de définition 24, 27 de la deuxième consigne est réalisée. Cette étape d'alerte peut comprendre alors une étape de transmission par l'unité de traitement 5 d'un message au niveau du tableau de bord de ce véhicule ou encore d'un signal sonore.

Avantageusement, ce dispositif 1 et ce procédé permettent d'assurer la protection du fusible 2 contre ses propres dérives thermiques et maintenir la température de ce dernier dans une zone de température dans laquelle son fonctionnement est optimal. De plus, ils permettent également d'assurer une prise en compte de la dynamique et du temps de réponse thermique du fusible 2.

## Revendications

1. Procédé de protection d'une architecture électrique (11) comprenant un dispositif (1) de protection pourvu d'un fusible (2) de protection apte à fondre dans un mode de fonctionnement dégradé durant lequel un courant de rupture d'une intensité supérieure à un seuil circule dans l'architecture (11), le procédé comportant en outre, dans un mode de fonctionnement nominal les étapes suivantes :
- estimation (17) périodique d'une température (Te) dudit fusible (2), et
- pilotage (23) d'une intensité (I) d'un courant utile circulant dans ledit fusible (2) de sorte que la température (Te) estimée reste inférieure à une température de fusion (Tf) dudit fusible (2)
le procédé étant **caractérisé en ce qu'**il comprend une étape de définition (26) d'une première consigne de limitation de l'intensité (I) du courant à une première intensité maximale (Im1) circulant dans ledit fusible (2) et **en ce que** l'étape de pilotage (23) comprend, si la température (Te) estimée est supérieure à une température seuil (Ts), une étape de définition (25, 28) d'une deuxième consigne de limitation de l'intensité de courant utile (I) à une deuxième intensité maximale (Im2) du courant, la deuxième consigne étant inférieure à la première.

2. Procédé selon la revendication précédente, **caractérisé en ce que** l'étape d'estimation (17) périodique de la température (Te) du fusible (2) comprend :
- une étape de mesure (18) de la température (Te) du fusible (2), notamment d'une lamelle (12) du fusible (2), ou
- une étape de mesure (20) de l'intensité (I) du courant circulant dans ledit fusible (2), notamment d'une lamelle (12) du fusible (2), et
- une étape de calcul (21) de la température (Te) à partir de l'intensité (I) mesurée et d'un modèle de données mettant en relation des températures avec des intensités relatives audit fusible (2).

3. Procédé selon l'une quelconque des revendications précédentes, **caractérisé en ce qu'**il comprend une étape de détermination (31) d'une température seuil (Ts) à partir d'une différence entre la température de fusion (Tf) du fusible (2) et une variation de températures (ΔT) relative à une énergie (Ed) que le fusible (2) est susceptible de dissiper, laquelle énergie (Ed) étant inférieure à une énergie de fusion (Ef) de ce fusible (2).

4. Procédé selon l'une quelconque des revendications précédentes, **caractérisé en ce que** :
- l'étape d'estimation (17) comprend une étape d'ajustement (19, 22) d'une température mesurée ou calculée du fusible (2) à partir d'une température ambiante (Ta) déterminée dudit fusible (2), et/ou
- les étapes d'estimation (17) et de pilotage (23) sont mises en œuvre par un algorithme du type régulateur PID ou analogue.

5. Dispositif de protection (1) d'une architecture électrique (11) mettant en œuvre un procédé de protection selon l'une quelconque des revendications précédentes, le dispositif (1) comportant un fusible (2) de protection apte à fondre dans un mode de fonctionnement dégradé durant lequel un courant de rupture d'une intensité supérieure à un seuil circule dans l'architecture (11), le dispositif étant **caractérisé en ce qu'**il comporte en outre, dans un mode de fonctionnement nominal :
- un élément d'estimation (3) périodique d'une température (Te) dudit fusible (2), l'élément d'estimation (3) comprenant une unité de traitement (5), au moins un capteur de température (7) du fusible (2), un dispositif de détermination (8) d'une température ambiante du fusible (2) et/ou au moins un dispositif de mesure (6) de l'intensité (I) du courant circulant dans ledit fusible (2), et
- un élément de pilotage (4) d'une intensité (I) d'un courant utile circulant dans ledit fusible (2) de sorte que la température (Te) estimée reste inférieure à une température de fusion (Tf) dudit fusible (2), l'élément de pilotage (4) comprenant l'unité de traitement (5) et un dispositif de régulation (9) de l'intensité (I) du courant circulant dans le fusible (2),
- l'unité de traitement (5) étant connectée audit au moins un capteur de température (7), aux dispositifs de mesure et de régulation (6, 9) de l'intensité (I) du courant circulant dans le fusible (2), ainsi qu'au dispositif de détermination (8) d'une température ambiante du fusible (2).

6. Véhicule notamment électrique ou hybride, comprenant une architecture électrique pourvue d'un dispositif de protection (1) selon la revendication 5.

## Patentansprüche

1. Verfahren zum Schutz einer elektrischen Architektur (11) mit einer Schutzvorrichtung (1), die mit einer Schutzsicherung (2) ausgestattet ist, die geeignet ist, in einem gestörten Betriebsmodus zu schmelzen, bei dem in der Architektur (11) ein Auslösestrom mit einer Stromstärke fließt, die einen Schwellenwert überschreitet, wobei das Verfahren darüber hinaus die folgenden Schritte aufweist:
- regelmäßige Schätzung (17) einer Temperatur (Te) der Sicherung (2) und
- Steuerung (23) einer Stromstärke (I) eines in der Sicherung (2) fließenden Nutzstroms in der Art, dass die geschätzte Temperatur (Te) unterhalb einer Schmelztemperatur (Tf) der Sicherung (2) bleibt,
wobei das Verfahren **dadurch gekennzeichnet ist, dass** es einen Schritt zur Festlegung (26) eines ersten Sollwerts zur Begrenzung der Stromstärke (I) auf eine erste maximale Stromstärke (Im1) aufweist, die in der Sicherung (2) fließt, und dass der Schritt zur Steuerung (23), falls die geschätzte Temperatur (Te) über einer Schwellentemperatur (Ts) liegt, einen Schritt zur Festlegung (25, 28) eines zweiten Sollwerts zur Begrenzung der Nutzstromstärke (I) auf eine zweite maximale Stromstärke (Im2) aufweist, wobei der zweite Sollwert niedriger ist als der erste.

2. Verfahren nach dem vorhergehenden Anspruch, **dadurch gekennzeichnet, dass** der Schritt zur regelmäßigen Schätzung (17) der Temperatur (Te) der Sicherung (2) Folgendes aufweist:
- einen Schritt zur Messung (18) der Temperatur (Te) der Sicherung (2), insbesondere einer Lamelle (12) der Sicherung (2), oder
- einen Schritt zur Messung (20) der Stromstärke (I) des durch die Sicherung (2) fließenden Stroms, insbesondere einer Lamelle (12) der Sicherung (2), und
- einen Schritt zur Berechnung (21) der Temperatur (Te) anhand der gemessenen Stromstärke (I) und eines Datenmodells, das Temperaturen mit den relativen Stromstärken der genannten Sicherung (2) in Beziehung setzt.

3. Verfahren nach einem der vorhergehenden Ansprüche, **dadurch gekennzeichnet, dass** es einen Schritt zur Ermittlung (31) einer Schwellentemperatur (Ts) auf der Grundlage einer Differenz zwischen der Schmelztemperatur (Tf) der Sicherung (2) und einer Temperaturänderung (ΔT) in Bezug auf eine Energie (Ed) aufweist, die die Sicherung (2) ableiten kann, wobei diese Energie (Ed) geringer ist als eine Schmelzenergie (Ef) dieser Sicherung (2).

4. Verfahren nach einem der vorhergehenden Ansprüche, **dadurch gekennzeichnet, dass**
- der Schritt zur Schätzung (17) einen Schritt zur Anpassung (19, 22) einer gemessenen oder berechneten Temperatur der Sicherung (2) auf der Grundlage einer ermittelten Umgebungstemperatur (Ta) der Sicherung (2) aufweist und/oder
- die Schritte zur Schätzung (17) und zur Steuerung (23) durch einen Algorithmus vom Typ PID-Regler oder ähnlichem umgesetzt werden.

5. Vorrichtung zum Schutz (1) einer elektrischen Architektur (11), die ein Schutzverfahren nach einem der vorhergehenden Ansprüche anwendet, wobei die Vorrichtung (1) mit einer Schutzsicherung (2) ausgestattet ist, die geeignet ist, in einem gestörten Betriebsmodus zu schmelzen, bei dem in der Architektur (11) ein Auslösestrom mit einer Stromstärke fließt, die einen Schwellenwert überschreitet, wobei die Vorrichtung **dadurch gekennzeichnet ist, dass** sie im Nennbetriebsmodus außerdem Folgendes enthält:
- ein Element zur regelmäßigen Schätzung (3) einer Temperatur (Te) der Sicherung (2), wobei das Schätzungselement (3) eine Verarbeitungseinheit (5), mindestens einen Temperatursensor (7) der Sicherung (2), eine Vorrichtung zur Ermittlung (8) einer Umgebungstemperatur der Sicherung (2) und/oder mindestens eine Vorrichtung zur Messung (6) der Stromstärke (I) des durch die Sicherung (2) fließenden Stroms aufweist, und
- ein Element zur Steuerung (4) einer Stromstärke (I) eines in der Sicherung (2) fließenden Nutzstroms in der Art, dass die geschätzte Temperatur (Te) unterhalb einer Schmelztemperatur (Tf) der Sicherung (2) bleibt, wobei das Steuerelement (4) die Verarbeitungseinheit (5) und eine Vorrichtung zur Regelung (9) der Stromstärke (I) des durch die Sicherung (2) fließenden Stroms aufweist,
- wobei die Verarbeitungseinheit (5) mit dem mindestens einen Temperatursensor (7), mit den Vorrichtungen zur Messung und Regelung (6, 9) der Stromstärke (I) des durch die Sicherung (2) fließenden Stroms sowie mit der Vorrichtung zur Ermittlung (8) einer Umgebungstemperatur der Sicherung (2) verbunden ist.

6. Fahrzeug, insbesondere ein Elektro- oder Hybridfahrzeug, das eine elektrische Architektur aufweist, die mit einer Schutzvorrichtung (1) nach Anspruch 5 ausgestattet ist.

## Claims

1. Method for protecting an electrical architecture (11) comprising a protective device (1) provided with a protective fuse (2) that is able to melt in an impaired mode of operation during which a break current, with a magnitude higher than a threshold, flows in the architecture (11), the method furthermore including, in a nominal mode of operation, the following steps:
- periodically estimating (17) a temperature (Te) of said fuse (2), and
- controlling (23) a magnitude (I) of a useful current flowing in said fuse (2) such that the estimated temperature (Te) remains lower than a melting temperature (Tf) of said fuse (2),
the method being **characterized in that** it comprises a step (26) of defining a first limit setpoint for the magnitude (I) of the current at a first maximum magnitude (Im1) flowing in said fuse (2) and **in that** the control step (23) comprises, if the estimated temperature (Te) is higher than a threshold temperature (Ts), a step (25, 28) of defining a second limit setpoint for the useful current magnitude (I) at a second maximum magnitude (Im2) of the current, the second setpoint being lower than the first.

2. Method according to the preceding claim, **characterized in that** the step (17) of periodically estimating the temperature (Te) of the fuse (2) comprises:
- a step (18) of measuring the temperature (Te) of the fuse (2), in particular of a strip (12) of the fuse (2), or
- a step (20) of measuring the magnitude (I) of the current flowing in said fuse (2), in particular of a strip (12) of the fuse (2), and
- a step (21) of calculating the temperature (Te) on the basis of the measured magnitude (I) and of a data model linking temperatures with magnitudes relating to said fuse (2).

3. Method according to any one of the preceding claims, **characterized in that** it comprises a step (31) of determining a threshold temperature (Ts) on the basis of a difference between the melting temperature (Tf) of the fuse (2) and a temperature variation (ΔT) relating to a power (Ed) that the fuse (2) is liable to dissipate, this power (Ed) being lower than a melting power (Ef) of this fuse (2).

4. Method according to any one of the preceding claims, **characterized in that**
- the estimation step (17) comprises a step (19, 22) of adjusting a measured or calculated temperature of the fuse (2) on the basis of a determined ambient temperature (Ta) of said fuse (2), and/or
- the estimation (17) and control (23) steps are implemented by an analogue or PID controller algorithm.

5. Device (1) for protecting an electrical architecture (11) implementing a protection method according to any one of the preceding claims, the device (1) including a protective fuse (2) able to melt in an impaired mode of operation during which a break current, with a magnitude higher than a threshold, flows in the architecture (11), the device being **characterized in that** it furthermore includes, in a nominal mode of operation:
- an element (3) for periodically estimating a temperature (Te) of said fuse (2), the estimation element (3) comprising a processing unit (5), at least one sensor (7) for sensing the temperature of the fuse (2), a device (8) for determining an ambient temperature of the fuse (2) and/or at least one device (6) for measuring the magnitude (I) of the current flowing in said fuse (2), and
- an element (4) for controlling a magnitude (I) of a useful current flowing in said fuse (2) such that the estimated temperature (Te) remains lower than a melting temperature (Tf) of said fuse (2), the control element (4) comprising the processing unit (5) and a device (9) for controlling the magnitude (I) of the current flowing in the fuse (2),
- the processing unit (5) being connected to said at least one temperature sensor (7), to the devices (6, 9) for measuring and controlling the magnitude (I) of the current flowing in the fuse (2), and to the device (8) for determining an ambient temperature of the fuse (2).

6. Vehicle, in particular an electric or hybrid vehicle, comprising an electrical architecture provided with a protective device (1) according to Claim 5.
